# EUROPEAN PATENT SPECIFICATION

(11) **EP 4 538 604 B1**
(45) Date of publication and mention of the grant of the patent: **09.12.2026**
(21) Application number: 23835138.1
(22) Date of filing: 01.05.2023
(51) Int. Cl.: H05K 1/02, H05K 1/18, F21V 23/00, F24F 11/38, F24F 1/20, F21V 19/00, F21V 33/00, F24F 1/56, F24F 11/52, H05K 1/181

(54) **OUTDOOR UNIT**
AUSSENEINHEIT
UNITÉ EXTÉRIEURE

(30) Priority: 08.07.2022 JP 2022110730
(43) Date of publication of application: 16.04.2025
(73) Proprietor: DAIKIN INDUSTRIES, LTD., Osaka-shi, Osaka 530-0001 (JP)
(72) Inventor: OGATA, Yuji, Osaka-shi, Osaka 530-0001 (JP); FUJIWARA, Masahide, Osaka-shi, Osaka 530-0001 (JP); KOTERA, Keito, Osaka-shi, Osaka 530-0001 (JP); UEDA, Narushige, Osaka-shi, Osaka 530-0001 (JP); HIROSE, Junichi, Osaka-shi, Osaka 530-0001 (JP); NAKATANI, Kazuhiro, Osaka-shi, Osaka 530-0001 (JP)
(74) Representative: Hoffmann Eitle
(86) International application number: PCT/JP2023/017063
(87) International publication number: WO 2024/009597

(56) References cited:
- WO-A1-2022/054128
- JP-A- 2015 119 010
- JP-A- 2015 119 010
- JP-A- H1 123 010
- JP-A- H1 123 010

## Description

### TECHNICAL FIELD

The present invention relates to an outdoor unit.

### BACKGROUND ART

An outdoor unit of an air conditioner of JP 2005-195209 A includes a substrate having an LED for failure diagnosis provided on a mounting surface and includes a reflector that reflects light from the LED. The reflector is provided to reflect light of the LED toward an inspection port.

WO 2022/054128 A1 relates to an outdoor unit having a side-and-back-surface plate.ss

### SUMMARY OF THE INVENTION

### TECHNICAL PROBLEM

One of the methods of making light of an LED on a substrate visible is to allow light of the LED to pass through the substrate in the thickness direction toward a solder surface which is the back side of the mounting surface on which a lead LED is mounted. In this method, a groove may be provided on the mounting surface to thin down part of the substrate. Emitting light toward the groove allows LED light passing through the substrate to be more visible.

However, mounting a lead LED requires soldering on the solder surface, for example. Further, if a groove is provided on the mounting surface to thin down the substrate, the grooved portion cannot be used effectively. In this manner, if the LED is provided on the substrate, the design of the substrate is not sufficiently flexible.

An object of the present invention is to make more flexible the design of a substrate on which an LED is provided.

### SOLUTION TO THE PROBLEM

A first aspect is directed to an outdoor unit of an air conditioner (1), comprising: a casing (30) having an opening (35) for maintenance; and a substrate (42) disposed in the casing (30) and including a first surface (42a) on which a predetermined electric component (41) is disposed and a second surface (42b) facing the opening (35), wherein the substrate (42) includes a light transmitting region (60) in which light is transmitted from the first surface (42a) toward the second surface (42b) when the second surface (42b) is viewed from front, and a first light source (46) provided on the first surface (42a), and the first light source (46) is a surface mount LED that emits light toward the light transmitting region (60).

According to the first aspect, the first light source (46) is a surface mount LED, and thus soldering of the second surface (42b) can be omitted, and also no thin portion needs to be provided unlike when a lead LED is mounted. As a result, the surface of the substrate (42) can be used effectively.

A second aspect is an embodiment of the first aspect. In the second aspect, the light transmitting region (60) is a region in which a light transmission reduction material (50a, 50b) that reduces light transmission between the first surface (42a) and the second surface (42b) is not provided.

According to the second aspect, a region in which the light transmission reduction material (50a, 50b) is not provided can serve as a light transmitting region. Accordingly, the light emitted from the first light source (46) toward the region in which the light transmission reduction material (50a, 50b) is not provided passes through the substrate (42), and thus the light of the first light source (46) is visible when the second surface (42b) is viewed from front.

A third aspect is an embodiment of the first or second aspect. In the third aspect, the first light source (46) includes a light emitter (46a) including an LED element, and a light emitting substrate (46b) provided on the first surface (42a) and configured to control light emission of the light emitter (46a), and the light emitter (46a) is adjacent to the light emitting substrate (46b) in a direction along the first surface (42a).

According to the third aspect, a side emitting chip LED can be employed as the first light source (46).

A fourth aspect is an embodiment of the first or second aspect. In the fourth aspect, the first light source (46) includes a light emitter (46a) including an LED element, and a light emitting substrate (46b) configured to control light emission of the light emitter (46a), and the light emitter (46a) is disposed between the first surface (42a) and the light emitting substrate (46b).

According to the fourth aspect, a back emitting chip LED can be employed as the first light source (46).

A fifth aspect is an embodiment of any one of the first to fourth aspects. In the fifth aspect, the outdoor unit further includes a second light source (47) disposed on the first surface (42a) at a predetermined distance from the first light source (46) and configured to emit light toward the first surface (42a); and a light transmission reduction material that reduces light transmission between the first surface (42a) and the second surface (42b), wherein the light transmission reduction material (50a, 50b) reduces transmission of light between the first surface (42a) and the second surface (42b), where the light is emitted from the second light source (47).

According to the fifth aspect, even when the first light source (46) and the second light source (47) are mounted on the first surface (42a), the light of the second light source (47) does not pass through the substrate (42) due to the light transmission reduction material (50a, 50b). Thus, only the light of the first light source (46) is visible when the second surface (42b) is viewed from front. Accordingly, a service person does not mistake the first light source (46) for the second light source (47), for example.

### BRIEF DESCRIPTION OF THE DRAWINGS

FIG. 1 is a piping system diagram of an air conditioner according to an embodiment.
FIG. 2 is a plan sectional view of a configuration of an outdoor unit.
FIG. 3 is a front sectional view of the configuration of the outdoor unit.
FIG. 4 is a longitudinal sectional view of a configuration of an electric component unit.
FIG. 5 is a partially enlarged view of a substrate as viewed from a pattern surface.
FIG. 6 is a side view of a surface mount LED mounted on the substrate.
FIG. 7 is a side view of two surface mount LEDs mounted on the substrate according to a variation.
FIG. 8 shows a surface mount LED according to another embodiment mounted on the substrate.

### DESCRIPTION OF EMBODIMENTS

An embodiment of the present invention will be described with reference to the drawings. The following embodiment is a merely exemplary one in nature, and is not intended to limit the scope, application, or uses of the invention which is defined by the claims. Features of the embodiment, variations, and other examples described below can be combined or partially substituted within the range where the present invention can be as long as falling within the scope of the claims In the drawings, the up and down, front and back, and left and right directions are indicated by arrows. Unless otherwise specified, directions such as up and down will be described in accordance with the directions indicated by these arrows.

### (1) Configuration of Air Conditioner

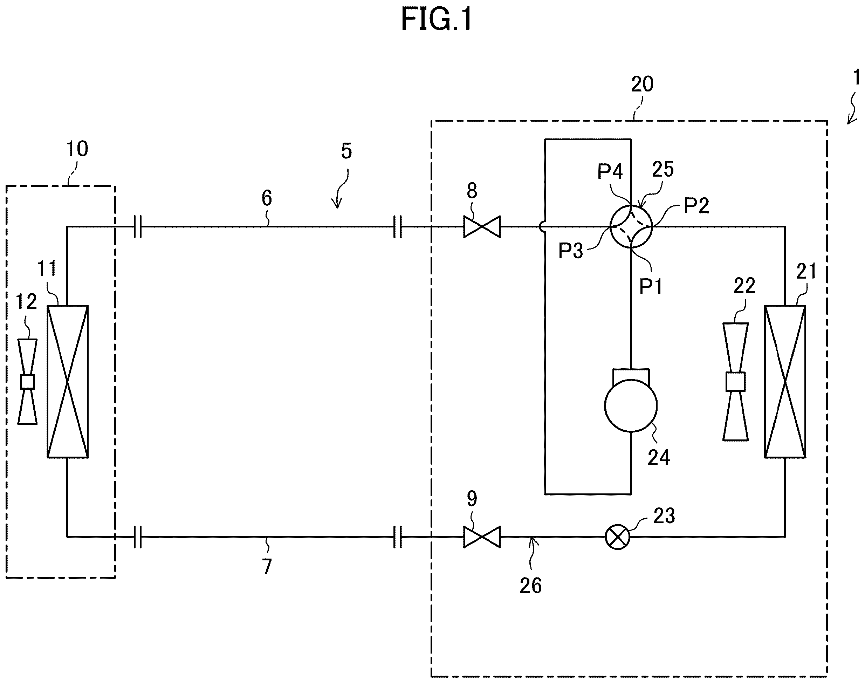

As shown in FIG. 1, the air conditioner (1) includes a refrigerant circuit (5) that circulates a refrigerant to perform a refrigeration cycle. The air conditioner (1) includes an indoor unit (10) and an outdoor unit (20). The indoor unit (10) is placed inside. The outdoor unit (20) is placed outside. The indoor unit (10) and the outdoor unit (20) are connected to each other by a gas pipe (6) and a liquid pipe (7). The gas pipe (6) is connected with a gas shut-off valve (8). The liquid pipe (7) is connected with a liquid shut-off valve (9).

### (2) Indoor Unit

The indoor unit (10) includes an indoor heat exchanger (11) and an indoor fan (12). The indoor heat exchanger (11) is, for example, a cross-fin type fin-and-tube heat exchanger. In the indoor heat exchanger (11), the refrigerant flowing inside the heat transfer tube and the air blown by the indoor fan (12) exchange heat.

### (3) Outdoor Unit

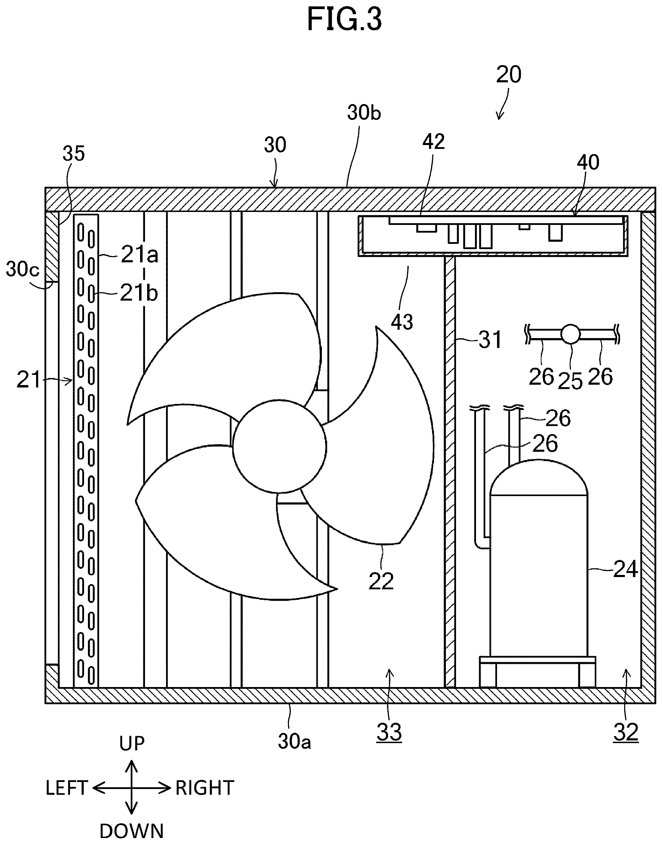

As shown in FIGS. 1 to 3, the outdoor unit (20) includes an outdoor heat exchanger (21), an outdoor fan (22), an outdoor expansion valve (23), a compressor (24), a four-way switching valve (25), and an electric component unit (40). The outdoor heat exchanger (21), the outdoor expansion valve (23), the compressor (24), and the four-way switching valve (25) are connected by a refrigerant pipe (26).

The outdoor heat exchanger (21) is, for example, a cross-fin type fin-and-tube heat exchanger. The outdoor heat exchanger (21) includes a plurality of fins (21a) and a heat transfer tube (21b). The plurality of fins (21a) are spaced in the direction orthogonal to the air flow direction. The heat transfer tube (21b) extends through the fins (21a) in the thickness direction. The heat transfer tube (21b) is disposed through multiple layers in the up-down direction.

In the outdoor heat exchanger (21), the refrigerant flowing inside the heat transfer tube (21b) and the air blown by the outdoor fan (22) exchange heat. The outdoor expansion valve (23) is, for example, an electronic expansion valve.

The compressor (24) is, for example, a rotary compressor such as a scroll compressor. The four-way switching valve (25) switches between a cooling operation and a heating operation. In the cooling operation, a first port (P1) and a second port (P2) of the four-way switching valve (25) communicate with each other, and a third port (P3) and a fourth port (P4) communicate with each other (the state indicated by the solid lines in FIG. 1). In the heating operation, the first port (P1) and the third port (P3) of the four-way switching valve (25) communicate with each other, and the second port (P2) and the fourth port (P4) communicate with each other (the state indicated by the broken lines in FIG. 1).

The outdoor unit (20) includes a casing (30). The casing (30) includes a body casing (30a) and a top panel (30b). The body casing (30a) is formed in a box shape where its upper surface is open. In other words, the upper surface of the body casing (30a) has an opening (35). The top panel (30b) is attached to the body casing (30a) so as to close the opening (35) of the main casing (30a). The top panel (30b) can be attached to and detached from the body casing (30a). The opening (35) of the body casing (30a) is an example of the opening (35) for maintenance of the outdoor unit (20).

In the body casing (30a), a partitioning member (31) extending in the front-back direction and the up-down direction is disposed. The partitioning member (31) partitions the inside of the body casing (30a) into a machine chamber (32) and a fan chamber (33).

In the body casing (30a), the machine chamber (32) is a space located to the right of the partitioning member (31). The compressor (24), the four-way switching valve (25), the refrigerant pipe (26), and the electric component unit (40) are disposed in the machine chamber (32).

In the body casing (30a), the fan chamber (33) is a space located to the left of the partitioning member (31). The outdoor fan (22) and the outdoor heat exchanger (21) are disposed in the fan chamber (33).

The body casing (30a) includes a back sidewall and a left sidewall, each of which is provided with a suction port (30c) communicating with the fan chamber (33). When the outdoor fan (22) is driven, outside air is sucked into the fan chamber (33) through the suction port (30c). The body casing (30a) includes a front sidewall which is provided with an outlet port (30d) communicating with the fan chamber (33). When the outdoor fan (22) is driven, air in the fan chamber (33) is blown out through the outlet port (30d).

### (4) Electric Component Unit

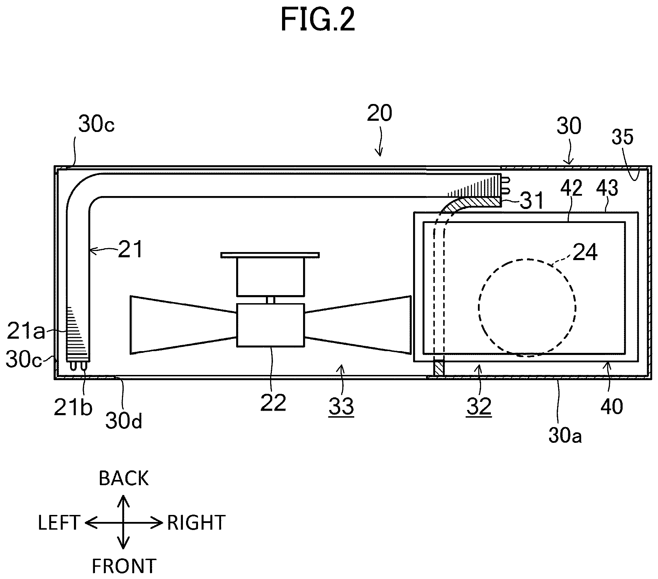

The electric component unit (40) serves as a power converter for supplying power to the motor of the compressor (24). As shown in FIGS. 2 to 4, the electric component unit (40) includes a substrate casing (43), predetermined electric components (41), a substrate (42), and a surface mount LED (46). The electric component unit (40) is disposed near the top panel (30b) above the machine chamber (32).

The substrate casing (43) is a box-shaped member having an opening at its top. The substrate casing (43) houses various electric components (41) including the substrate (42). Only one substrate (42) is disposed in the substrate casing (43) of this embodiment. The opening at the top of the substrate casing (43) faces the lower surface of the top panel (30b).

The electric components (41) are mounted on the substrate (42). The electric components (41) are control circuit components such as power transistors, microcomputer chips for controlling devices, or a memory for storing control programs.

A heat sink (not shown) is provided as a member for reducing temperature increases of the electric components (41) such as power transistors that generate a relatively large amount of heat. The heat sink consists of a metal member.

### (4-1) Substrate

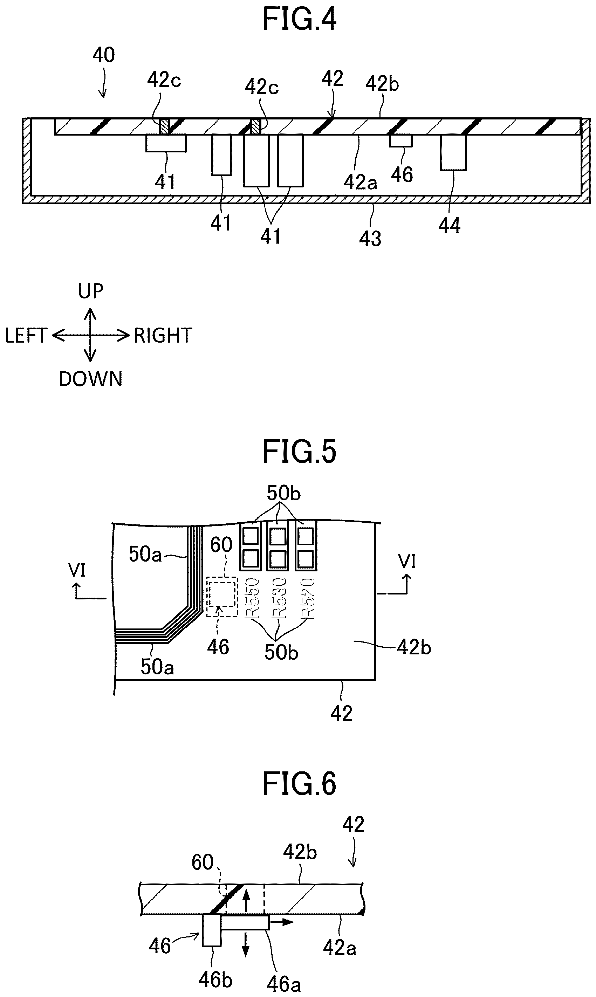

As shown in FIG. 4, the substrate (42) includes a mounting surface (42a) and a pattern surface (42b). The mounting surface (42a) is an example of the first surface (42a). The pattern surface (42b) is an example of the second surface (42b). The substrate (42) is disposed so that the pattern surface (42b) faces the opening (35) of the body casing (30a). In other words, the substrate (42) is disposed so that the pattern surface (42b) faces upward and the mounting surface (42a) faces downward. The substrate (42) of this embodiment is a single layer.

The electric component (41) and the surface mount LED (46) are disposed on the mounting surface (42a). The details of the surface mount LED (46) will be described later. Various connectors (44) are also mounted on the mounting surface (42a). The connectors (44) are used for, for example, connecting an output (AC power) of an inverter circuit (not shown) to a load (motor).

The substrate (42) has a plurality of through holes (hereinafter referred to as through holes (42c)). The through holes (42c) are formed for the purpose of, for example, conducting electricity between the mounting surface (42a) and the pattern surface (42b). Terminals of the electric component (41) are soldered on wiring patterns of the substrate (42).

As shown in FIG. 5, the wiring patterns (50a) are formed on the pattern surface (42b). Various electric components (41) are electrically connected to the wiring patterns (50a), thereby forming a predetermined circuit. Silk (50b) is applied onto the pattern surface (42b). The silk (50b) is a coating material for labeling the pattern surface (42b) with predetermined information such as a part number, a manufacturer logo, and a manufacture date. The wiring pattern (50a) and the silk (50b) are examples of the light transmission reduction material (50a, 50b). The light transmission reduction material (50a, 50b) reduces light transmission between the mounting surface (42a) and the pattern surface (42b).

As shown in FIGS. 5 and 6, the substrate (42) includes a light transmitting region (60). The light transmitting region (60) is a region in which when the pattern surface (42b) is viewed from front, light is transmitted from the mounting surface (42a) to the pattern surface (42b). In other words, the light transmitting region (60) is a region in which a pattern wire or a silk as the light transmission reduction material (50a, 50b) is not provided.

### (4-2) Surface Mount LED

The surface mount LED (46) is a light source for informing a service person about a microcomputer operation, a communication state, an error state, or the like of the substrate (42). The surface mount LED (46) is a chip LED provided on the mounting surface (42a). In this embodiment, when the air conditioner (1) is operating normally, the surface mount LED (46) is blinking. The surface mount LED (46) is an example of the first light source (46).

As shown in FIG. 6, the surface mount LED (46) of this embodiment is a side emitting chip LED. Specifically, the surface mount LED (46) includes a light emitter (46a) and a light emitting substrate (46b).

The light emitter (46a) is a member that emits light of an LED. Specifically, the light emitter (46a) includes an LED element and an encapsulating resin. The LED element is encapsulated in the encapsulating resin. The encapsulating resin is a transparent or translucent resin (silicone, epoxy resin, or the like). The encapsulating resin is formed in a substantially rectangular parallelepiped shape. The light emitting substrate (46b) controls light emission of the LED element of the light emitter (46a). The light emitting substrate (46b) is attached on the mounting surface (42a).

The light emitter (46a) is adjacent to the light emitting substrate (46b) in the direction along the mounting surface (42a). Accordingly, as indicated by the arrows in FIG. 6, the light emitter (46a) emits light toward the mounting surface (42a) and also emits light in the direction along the mounting surface (42a).

The light emitter (46a) is disposed not to overlap the wiring pattern (50a) or the silk (50b) when the pattern surface (42b) is viewed from front. In other words, the surface mount LED (46) emits light toward the light transmitting region (60). Accordingly, part of LED light emitted from the light emitter (46a) is transmitted from the mounting surface (42a) toward the pattern surface (42b), and the light of the surface mount LED is visible when viewed from the pattern surface.

### (5) Features

### (5-1) First Feature

In the outdoor unit (20) of this embodiment, the substrate (42) includes the light transmitting region (60) in which light is transmitted from the mounting surface (42a) (the first surface) toward the pattern surface (42b) (the second surface) when the pattern surface (42b) (the second surface) is viewed from front. The substrate (42) also includes the surface mount LED (46) provided on the mounting surface (42a) and configured to emit light toward the light transmitting region (60).

According to this embodiment, the surface mount LED is mounted as the light source on the mounting surface (42a), and thus the design of the substrate (42) is more flexible than if a lead LED is mounted. Specifically, a lead LED requires two leads connected to the LED and also soldered to the pattern surface (42b) via the through holes (42b). Then, a slit (recess) is formed on part of the mounting surface (42a) that faces the LED (specifically, a position between the two leads) to enable LED light to transmit more easily, so that the substrate (42) is locally thinner. If a lead LED is used as a light source in this manner, the available areas of the mounting surface (42a) and the pattern surface (42b) are smaller, and the design is less flexible. However, if the surface mount LED (46) is used, soldering on the pattern surface (42b) can be omitted, and also no slit needs to be provided and thus the surface of the substrate (42) can be used more effectively.

In addition, since the light of the surface mount LED (46) emitted to the light transmitting region (60) is transmitted through the substrate (42) in the thickness direction, the light of the surface mount LED (46) is visible when viewed from the pattern surface (42b). Accordingly, the state of light of the surface mount LED (46) can be checked by simply opening the top panel (30b) of the outdoor unit (20). As a result, a service person can easily check a microcomputer operation, a communication state, or an error state of the substrate (42).

### (5-2) Second Feature

In the outdoor unit (20) of this embodiment, the light transmitting region (60) is a region in which the wiring pattern (50a) and the silk (50b) (the light transmission reduction material) that reduce light transmission between the mounting surface (42a) and the pattern surface (42b) are not provided.

According to this embodiment, in the light transmitting region (60), the wiring pattern (50a) and the silk are not provided. Thus, when light of the surface mount LED (46) is emitted to that region, light is visible from the pattern surface (42b).

### (5-3) Third Feature

In the outdoor unit (20) of this embodiment, the surface mount LED (46) is a side emitting chip LED. The light emitted from the light emitter (46a) of the side emitting LED toward the mounting surface (42a) can be transmitted through the substrate (42) in the thickness direction. In addition, the LEDs of the outdoor unit (20) can consist of only the side emitting chip LEDs. Thus, it is unnecessary to use different types of LEDs particularly for the LEDs provided on the substrate (42), and the manufacturing costs and the complex management of the components can be reduced.

### (6) Variations

Variations of the outdoor unit (20) of the present disclosure will be described. Configurations different from those of the embodiment will be described.

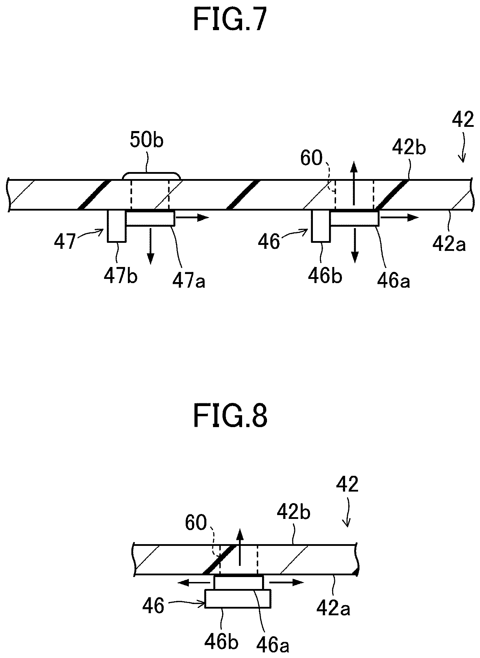

As shown in FIG. 7, two surface mount LEDs (46, 47) are mounted on the mounting surface (42a) of the substrate (42) of this example. One of the surface mount LEDs is referred to as a first surface mount LED (46), and the other one of the surface mount LEDs is referred to as a second surface mount LED (47). The first surface mount LED (46) and the second surface mount LED (47) are spaced apart from each other at a predetermined distance. The first surface mount LED (46) is an example of the first light source (46). The second surface mount LED (47) is an example of the second light source (47). The first surface mount LED (46) and the second surface mount LED (47) have the same configuration as those of the side emitting LED of the embodiment. The second surface mount LED (47) includes a light emitter (47a) and a light emitting substrate (47b).

The first surface mount LED (46) is a light source for informing a service person about a microcomputer operation, a communication state, an error state, or the like of the substrate (42). The second surface mount LED (47) is a light source for an operator to check the quality of the substrate (42) in the manufacturing process of the substrate (42), for example. That is, the second surface mount LED (47) is a light source that a service person does not need to check.

The substrate (42) of this example includes a light transmission reduction material (50a, 50b) that reduces transmission of light toward the mounting surface (42a) of the second surface mount LED (47). Specifically, the light transmission reduction material is a silk (50b) applied onto the pattern surface (42b). The silk (50b) is applied to part of the pattern surface (42b) on which the second surface mount LED (47) is disposed.

Accordingly, even if the second surface mount LED (47) emits light, the silk (50b) reduces transmission of light toward the mounting surface (42a) through the substrate (42) (see the arrow in FIG. 7). Accordingly, a service person can visually check the first surface mount LED (46) only, and does not mistake the light of the first surface mount LED (46) for the light of the second surface mount LED (47).

### (7) Other Embodiments

The above embodiment and variations may be configured as follows.

As shown in FIG. 8, the surface mount LED (46) may be a back emitting chip LED. In the back emitting LED, the light emitter (46a) is disposed between the light emitting substrate (46b) and the mounting surface (42a). The light emitting substrate (46b) is conductively connected to the substrate (42). The light emitter (46a) emits light toward the mounting surface (42a) and along the mounting surface (42a) (see the arrows in FIG. 8). Part of the light toward the mounting surface (42a) passes through the light transmitting region. That is, even the back emitting chip LED enables light transmitted through the substrate (42) to be visible from the pattern surface (42b).

The substrate (42) may be comprised of a plurality of substrates (42). In this case, the light transmitting region (60) is a region in which light is transmitted through layers. In other words, the light transmitting region (60) is a region in which the wiring pattern (50a) and the silk (50b) are not provided in each layer. Thus, even the multilayer substrate (42), where the surface mount LED (46) is disposed on part of the mounting surface (42a) that corresponds to the light transmitting region (60), enables LED light to be visible from the back surface (pattern surface (42b)) of the mounting surface (42a).

In the variation, the light transmission reduction material (50a, 50b) may be the wiring pattern (50a). Specifically, the second surface mount LED (47) may be disposed on the back surface (mounting surface (42a)) of the wiring pattern (50a). Accordingly, light from the second surface mount LED (47) toward the substrate (42) is less transmitted through the substrate (42) by the wiring pattern (50a).

While the embodiment and variations thereof have been described above, it will be understood that various changes in form and details may be made without departing from the scope of the claims. The embodiment and the variations thereof may be combined and replaced with each other without deteriorating intended functions of the present invention. The expressions of "first," "second," . . . described above are used to distinguish the terms to which these expressions are given, and do not limit the number and order of the terms.

### INDUSTRIAL APPLICABILITY

As described above, the present invention is useful for an outdoor unit.

### DESCRIPTION OF REFERENCE CHARACTERS

- 1: Air Conditioner
- 20: Outdoor Unit
- 30: Casing
- 35: Opening
- 41: Electric Component
- 42: Substrate
- 42a: Mounting Surface (First Surface)
- 42b: Pattern Surface (Second Surface)
- 46: Surface Mount LED, First Surface Mount LED (First Light Source)
- 46a: Light Emitter
- 46b: Light Emitting Substrate
- 47: Second Surface Mount LED (Second Light Source)
- 50a, 50b: Light Transmission Reduction Material
- 60: Light Transmitting Region

## Claims

1. An outdoor unit of an air conditioner (1), comprising:
a casing (30) having an opening (35) for maintenance; and
a substrate (42) disposed in the casing (30) and including a first surface (42a) on which an electric component (41) is disposed and a second surface (42b) facing the opening (35),
wherein
the substrate (42) includes
a light transmitting region (60) in which light is transmitted from the first surface (42a) toward the second surface (42b) when the second surface (42b) is viewed from front, and
a first light source (46) provided on the first surface (42a), and
the first light source (46) is a surface mount LED that emits light toward the light transmitting region (60).

2. The outdoor unit of claim 1, wherein
the light transmitting region (60) is a region in which a light transmission reduction material (50a, 50b) that reduces light transmission between the first surface (42a) and the second surface (42b) is not provided.

3. The outdoor unit of claim 1 or 2, wherein
the first light source (46) includes
a light emitter (46a) including an LED element, and
a light emitting substrate (46b) provided on the first surface (42a) and configured to control light emission of the LED element, and
the light emitter (46a) is adjacent to the light emitting substrate (46b) in a direction along the first surface (42a).

4. The outdoor unit of claim 1 or 2, wherein
the first light source (46) includes
a light emitter (46a) including an LED element, and
a light emitting substrate (46b) provided on the first surface (42a) and configured to control light emission of the LED element, and
the light emitter (46a) is disposed between the first surface (42a) and the light emitting substrate (46b).

5. The outdoor unit of any one of claims 1 to 4, further comprising:
a second light source (47) disposed on the first surface (42a) at a predetermined distance from the first light source (46) and configured to emit light toward the first surface (42a); and
a light transmission reduction material (50a, 50b) that reduces light transmission between the first surface (42a) and the second surface (42b),
wherein
the light transmission reduction material (50a, 50b) reduces transmission of light between the first surface (42a) and the second surface (42b), where the light is emitted from the second light source (47).

## Patentansprüche

1. Außeneinheit einer Klimaanlage (1), umfassend:
ein Gehäuse (30), das eine Öffnung (35) zur Wartung aufweist; und
ein Substrat (42), das in dem Gehäuse (30) angeordnet ist, und eine erste Oberfläche (42a), an der ein elektrisches Bauteil (41) angeordnet ist, und eine zweite Oberfläche (42b) einschließt, die der Öffnung (35) zugewandt ist,
wobei
das Substrat (42)
einen lichtdurchlässigen Bereich (60), in dem Licht von der ersten Oberfläche (42a) zur zweiten Oberfläche (42b) übertragen wird, wenn die zweite Oberfläche (42b) von vorn betrachtet wird, und
eine an der ersten Oberfläche (42a) bereitgestellte erste Lichtquelle (46) einschließt, und
die erste Lichtquelle (46) eine oberflächenmontierte LED ist, die Licht in Richtung des lichtdurchlässigen Bereichs (60) emittiert.

2. Außeneinheit nach Anspruch 1, wobei
der lichtdurchlässige Bereich (60) ein Bereich ist, in dem ein Material (50a, 50b), das die Lichtdurchlässigkeit zwischen der ersten Oberfläche (42a) und der zweiten Oberfläche (42b) verringert, nicht bereitgestellt ist.

3. Außeneinheit nach Anspruch 1 oder 2, wobei
die erste Lichtquelle (46)
einen Lichtemitter (46a), der ein LED-Element einschließt, und
ein lichtemittierendes Substrat (46b) einschließt, das an der ersten Oberfläche (42a) bereitgestellt ist und ausgebildet ist, um die Lichtemission des LED-Elements zu steuern, und
der Lichtemitter (46a) benachbart zu dem lichtemittierenden Substrat (46b) in einer Richtung entlang der ersten Oberfläche (42a) angeordnet ist.

4. Außeneinheit nach Anspruch 1 oder 2, wobei
die erste Lichtquelle (46)
einen Lichtemitter (46a), der ein LED-Element einschließt, und
ein lichtemittierendes Substrat (46b) einschließt, das an der ersten Oberfläche (42a) bereitgestellt ist und ausgebildet ist, um die Lichtemission des LED-Elements zu steuern, und
der Lichtemitter (46a) zwischen der ersten Oberfläche (42a) und dem lichtemittierenden Substrat (46b) angeordnet ist.

5. Außeneinheit nach einem der Ansprüche 1 bis 4, weiter umfassend:
eine zweite Lichtquelle (47), die auf der ersten Oberfläche (42a) in einem vorbestimmten Abstand von der ersten Lichtquelle (46) angeordnet ist, und ausgebildet ist, um Licht in Richtung der ersten Oberfläche (42a) zu emittieren; und
ein Material (50a, 50b), das die Lichtdurchlässigkeit zwischen der ersten Oberfläche (42a) und der zweiten Oberfläche (42b) verringert,
wobei
das die Lichtdurchlässigkeit verringernde Material (50a, 50b) die Durchlässigkeit von Licht zwischen der ersten Oberfläche (42a) und der zweiten Oberfläche (42b) verringert, wobei das Licht von der zweiten Lichtquelle (47) emittiert wird.

## Revendications

1. Unité extérieure d'un climatiseur (1), comprenant :
un boîtier (30) présentant une ouverture (35) pour la maintenance ; et
un substrat (42) disposé dans le boîtier (30) et incluant une première surface (42a) sur laquelle un composant (41) électrique est disposé et une deuxième surface (42b) faisant face à l'ouverture (35),
dans laquelle
le substrat (42) inclut
une région (60) de transmission de lumière dans laquelle une lumière est transmise à partir de la première surface (42a) vers la deuxième surface (42b) lorsque la deuxième surface (42b) est vue de face, et
une première source (46) de lumière fournie sur la première surface (42a), et
la première source (46) de lumière est une LED montée en surface qui émet une lumière vers la région (60) de transmission de lumière.

2. Unité extérieure selon la revendication 1, dans laquelle
la région (60) de transmission de lumière est une région dans laquelle un matériau (50a, 50b) de réduction de transmission de lumière qui réduit la transmission de lumière entre la première surface (42a) et la deuxième surface (42b) n'est pas fourni.

3. Unité extérieure selon la revendication 1 ou la revendication 2, dans laquelle
la première source (46) de lumière inclut
un émetteur (46a) de lumière incluant un élément à LED, et
un substrat (46b) d'émission de lumière fourni sur la première surface (42a) et configuré pour commander l'émission de lumière de l'élément à LED, et
l'émetteur (46a) de lumière est adjacent au substrat (46b) d'émission de lumière dans une direction le long de la première surface (42a).

4. Unité extérieure selon la revendication 1 ou la revendication 2, dans laquelle
la première source (46) de lumière inclut
un émetteur (46a) de lumière incluant un élément à LED, et
un substrat (46b) d'émission de lumière fourni sur la première surface (42a) et configuré pour commander l'émission de lumière de l'élément à LED, et
l'émetteur (46a) de lumière est disposé entre la première surface (42a) et le substrat (46b) d'émission de lumière.

5. Unité extérieure selon l'une quelconque des revendications 1 à 4, comprenant en outre :
une deuxième source (47) de lumière disposée sur la première surface (42a) à une distance prédéterminée de la première source (46) de lumière et configurée pour émettre une lumière vers la première surface (42a) ; et
un matériau (50a, 50b) de réduction de transmission de lumière qui réduit la transmission de lumière entre la première surface (42a) et la deuxième surface (42b),
dans laquelle
le matériau (50a, 50b) de réduction de transmission de lumière réduit la transmission de lumière entre la première surface (42a) et la deuxième surface (42b), où la lumière est émise à partir de la deuxième source (47) de lumière.
